# EUROPÄISCHE PATENTSCHRIFT

(11) **EP 1 586 164 B1**
(45) Veröffentlichungstag und Bekanntmachung des Hinweises auf die Patenterteilung: **06.05.2009**
(21) Anmeldenummer: 04702297.5
(22) Anmeldetag: 15.01.2004
(51) Int. Cl.: H03K 17/96

(54) **SCHALTUNGSANORDNUNG FÜR EINEN KAPAZITIVEN NÄHERUNGSSCHALTER**
CIRCUIT ARRANGEMENT FOR A CAPACITIVE PROXIMITY SWITCH
CIRCUIT D'UN DETECTEUR DE PROXIMITE CAPACITIF

(30) Priorität: 24.01.2003 DE 10303480
(43) Veröffentlichungstag der Anmeldung: 19.10.2005
(73) Patentinhaber: E.G.O. ELEKTRO-GERÄTEBAU GmbH, D-75038 Oberderdingen (DE)
(72) Erfinder: KRAUS, Randolf, 75015 Bretten (DE)
(74) Vertreter: Patentanwälte Ruff, Wilhelm, Beier, Dauster & Partner
(86) Internationale Anmeldenummer: PCT/EP2004/000236
(87) Internationale Veröffentlichungsnummer: WO 2004/066498

(56) Entgegenhaltungen:
- EP-A- 0 859 468
- DE-A- 19 528 454
- DE-A- 19 701 899
- US-A- 4 345 167
- US-A- 4 743 837

## Beschreibung

### Anwendungsgebiet und Stand der Technik

Die Erfindung bezieht sich auf eine Schaltungsanordnung für einen kapazitiven Näherungsschalter nach dem Oberbegriff des Anspruchs 1, insbesondere nach dem Ladungstransferprinzip.

Schaltungsanordnungen dieser Art sind bekannt und weisen beispielsweise bei der EP 0 859 468 A1 ein kapazitives Sensorelement auf, dessen Kapazität sich in Abhängigkeit seines Betätigungszustands ändert. Diese Kapazitätsänderung wird ausgewertet, um den Betätigungszustand zu ermitteln. Hierzu wird das Sensorelement mit einer Ladespannung beaufschlagt, wodurch in Abhängigkeit von dessen Kapazität und der Ladespannung eine bestimmte elektrische Ladung auf das Sensorelement transferiert wird. Nach einer Ladezeit wird das Sensorelement von der Ladespannung getrennt und mit einem Sammelkondensator verbunden, wodurch ein Ladungstransfer vom Sensorelement auf den Sammelkondensator erfolgt. Der Vorgang des Ladens und anschließenden Umladens wird für eine vorbestimmte Anzahl von Zyklen wiederholt, wodurch die Ladung des Sammelkondensators einen bestimmten Wert erreicht, der unter anderem durch den Wert der Kapazität des Sensorelements bestimmt wird. Die Ladung bzw. die daraus resultierende Spannung des Sammelkondensators ist folglich ein Maß für die zu messende Kapazität des Sensorelements. Durch Auswerten der Spannung des Sammelkondensators kann auf den Betätigungszustand des Näherungsschalters geschlossen werde. Nach der Spannungsauswertung wird der Sammelkondensator definiert entladen und es kann sich ein neuer Messzyklus anschließen.

Die Schaltvorgänge werden herkömmlicherweise durch Analogschalter realisiert, die relativ teuer sind. Weiterhin kann sich das Sensorelement nur bis auf die momentane Spannung des Sammelkondensators entladen, wodurch die transferierbare Ladung mit zunehmender Aufladung des Sammelkondensators abnimmt und folglich die Signalauflösung reduziert wird.

Die US 4,345,167, die US 4,743,837 und die DE 195 28 454 C1 zeigen jeweils Schaltungsanordnungen zur Kapazitätsmessung, bei denen eine Ladespannung, mit der ein zu messender Kondensator beaufschlagt wird, eine Gleichspannung ist.

### Aufgabe und Lösung

Der Erfindung liegt die Aufgabe zugrunde, eine Schaltungsanordnung der eingangs genannten Art bereitzustellen, die eine sichere Bestimmung des Betätigungszustands des Näherungsschalters unter allen Betriebsbedingungen gewährleistet, kostengünstig herstellbar und unempfindlich gegenüber EMV- und HF-Störungen ist.

Die Erfindung löst diese Aufgabe durch eine Schaltungsanordnung mit den Merkmalen des Anspruchs 1. Vorteilhafte sowie bevorzugte Ausgestaltungen der Erfindung sind Gegenstand der weiteren Ansprüche und werden im folgenden näher erläutert. Der Wortlaut der Ansprüche wird durch ausdrückliche Bezugnahme zum Inhalt der Beschreibung gemacht.

Die erfindungsgemäße Schaltungsanordnung umfasst ein erstes steuerbares Verbindungsmittel, das in Abhängigkeit von einem Ansteuersignal ein kapazitives Sensorelement mit einer Ladespannung beaufschlagt, und ein zweites steuerbares Verbindungsmittel, das in Abhängigkeit vom Ansteuersignal das kapazitive Sensorelement mit einem Sammelkondensator zum Transfer der Ladung vom kapazitiven Sensorelement auf den Sammelkondensator verbindet. Dabei ist die Ladespannung eine Wechselspannung und die Verbindungsmittel sind derart mit der Wechselspannung beaufschlagbar, dass im Wechsel das erste Verbindungsmittel oder das zweite Verbindungsmittel leitend sind. Die Umschaltung zwischen einer Ladephase des Sensorelements und der Ladungstransferphase erfolgt im Takt der Wechselspannung, wodurch eine zusätzliche Umschaltlogik entfallen kann. Eine derartige Schaltungsanordnung ist einfach aufzubauen, kostengünstig herzustellen und unempfindlich gegenüber Störungen.

In einer Weiterbildung der Schaltungsanordnung wird die Ladespannung mit Hilfe einer Gleichspannungsquelle und einer Rechteckspannungsquelle mit gemeinsamem Bezugspotential erzeugt. Dabei sind zwischen einem Ladespannungsknoten und der Gleichspannungsquelle eine Klemmdiode in Sperrrichtung eingeschleift und zwischen dem Ladespannungsknoten und der Rechteckspannungsquelle ein Kondensator und ein Widerstand in Serie eingeschleift. Durch eine derartige Anordnung ist es möglich, eine rechteckförmige Ladespannung am Ladespannungsknoten zu erzeugen, die zwischen dem Potential der Gleichspannungsquelle und einem Summenpotential der Potentiale der Gleichspannungsquelle und dem "1"-Pegel bzw. -Potential der Rechteckspannungsquelle im Takt der Rechteckspannungsquelle alterniert. Dies ermöglicht eine annähernd vollständige Auf- bzw. Entladung des Sensorelements unabhängig von der Ladespannung bzw. des Ladezustands des Sammelkondensators, wodurch ein linearer Spannungsanstieg am Sammelkondensator bewirkt wird. Die mögliche Signalauflösung wird dadurch stark verbessert.

In einer Weiterbildung der Schaltungsanordnung ist das erste Verbindungsmittel eine Diode und/oder das zweite Verbindungsmittel ein Bipolar-Transistor, insbesondere ein pnp-Transistor. Mit Hilfe dieser Wahl der Verbindungsmittel ist es einfach und kostengünstig möglich, eine Schaltfunktion in Abhängigkeit von der Ladespannung zu realisieren, da die Verbindungsmittel in Abhängigkeit von der Ladespannung leitend bzw. sperrend sind. Teure und empfindliche Analogschalter können entfallen. Weiterhin wird eine für kapazitive Sensorelemente typische Grundkapazität weitestgehend durch die parasitären Transistor-Kapazitäten kompensiert, wodurch im wesentlichen nur die Kapazitätsänderung des Sensorelements erfasst wird.

In einer Weiterbildung der Schaltungsanordnung sind die Basis des Transistors und/oder die Anode der Diode mit dem Ladespannungsknoten verbunden, die Kathode der Diode und/oder der Emitter des Transistors mit einem Filterwiderstand verbunden, der mit dem kapazitiven Sensorelement gekoppelt ist, und der Kollektor des Transistors ist mit dem Sammelkondensator verbunden, dessen anderer Anschluss mit einem Bezugspotential verbunden ist. Durch diese Beschaltung wird erreicht, dass die Diode bzw. der Transistor in Abhängigkeit von der Ladespannung im Wechsel leitend sind, weitere Steuersignale sind nicht notwendig. Der Filterwiderstand macht die Schaltungsanordnung unempfindlich gegenüber EMV- und HF-Störungen.

In einer Weiterbildung der Schaltungsanordnung ist dem Sammelkondensator ein Schalter parallel geschaltet. Dies ermöglicht ein sicheres Entladen des Sammelkondensators vor dem Beginn einer neuen Messung. Alternativ kann auch ein geeignet dimensionierter Widerstand eingesetzt werden.
In einer Weiterbildung der Schaltungsanordnung weist die Schaltungsanordnung mehrere kapazitive Sensorelemente, denen jeweils ein erstes und ein zweites Verbindungsmittel zugeordnet ist, und lediglich einen einzigen Sammelkondensator auf, der mit den jeweiligen zweiten Verbindungsmitteln über jeweils eine Entkopplungsdiode in Durchlassrichtung verbunden ist, wobei die Anode der Entkopplungsdiode durch eine Selektionsdiode in Durchlassrichtung mit einem jeweiligen Selektionssignal verbunden ist. Mit Hilfe einer derartigen Schaltungsanordnung ist es möglich, den Betätigungszustand mehrerer Näherungsschalter im Multiplexbetrieb auszuwerten. Die Auswahl des entsprechenden Näherungsschalters erfolgt durch das Selektionssignal, durch das der Ladungstransfer vom ausgewählten Sensorelement auf den einzigen Sammelkondensator freigegeben wird. Die Ladung der nicht selektierten Sensorelemente fließt über die jeweilige Selektionsdiode ab. Die Ladespannung kann zentral zur Verfügung gestellt werden.

In einer Weiterbildung der Schaltungsanordnung ist das kapazitive Sensorelement dazu ausgebildet, an eine Unterseite einer Fläche oder Abdeckung mit dielektrischen Eigenschaften angelegt zu werden, wobei sie vorzugsweise eine glatte ebene Oberfläche zur Anlage aufweist.

In einer Weiterbildung der Schaltungsanordnung ist das kapazitive Sensorelement ein voluminöser, elastischer, vorzugsweise länglicher Körper aus elektrisch leitfähigem Material. Ein solches Sensorelement ist beispielsweise in der EP 0 859 467 A1 beschrieben, deren Inhalt diesbezüglich durch ausdrückliche Bezugnahme zum Inhalt dieser Beschreibung gemacht wird.

Diese und weitere Merkmale gehen außer aus den Ansprüchen auch aus der Beschreibung und den Zeichnungen hervor, wobei die einzelnen Merkmale jeweils für sich allein oder zu mehreren in Form von Unterkombinationen bei einer Ausführungsform der Erfindung und auf anderen Gebieten verwirklicht sein und vorteilhafte sowie für sich schutzfähige Ausführungen darstellen können, für die hier Schutz beansprucht wird. Die Unterteilung der Anmeldung in einzelne Abschnitte sowie Zwischen-Überschriften beschränkt die unter diesen gemachten Aussagen nicht in ihrer Allgemeingültigkeit.

### Kurzbeschreibung der Zeichnungen

Vorteilhafte Ausführungsformen der Erfindung sind in den Zeichnungen schematisch dargestellt und werden nachfolgend beschrieben. Hierbei zeigen:
- Fig. 1: ein Schaltbild einer Schaltungsanordnung für kapazitive Näherungsschalter zur Bestimmung ihres Betätigungszustands,
- Fig. 2: ein Diagramm des Spannungsverlaufs einer Wechselspannungsquelle U2 von Fig. 1 und einer Ladespannung an einem Ladespannungsknoten N1 von Fig. 1,
- Fig. 3: ein Diagramm des Spannungsverlaufs an einem Sammelkondensator C2 von Fig. 1 in Abhängigkeit des Betätigungszustands eines Näherungsschalters und
- Fig. 4: ein Schaltbild einer Schaltungsanordnung mit mehreren kapazitiven Sensorelementen.

### Detaillierte Beschreibung der Ausführungsbeispiele

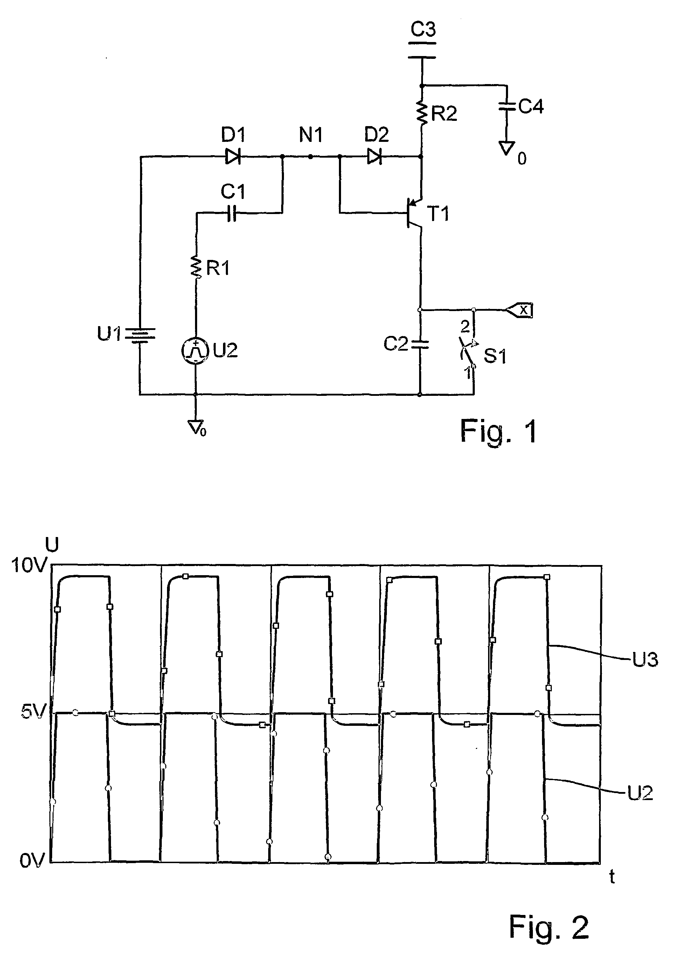

Fig. 1 zeigt ein Schaltbild einer Schaltungsanordnung für kapazitive Näherungsschalter zur Bestimmung ihres Betätigungszustands. Die Schaltungsanordnung umfasst eine Gleichspannungsquelle U1 und eine Rechteckspannungsquelle U2 mit gemeinsamen Bezugspotential, beispielsweise Masse, wobei zwischen einem Ladespannungsknoten N1, an dem eine Ladespannung anliegt, und der Gleichspannungsquelle U1 eine Klemmdiode D1 in Sperrrichtung eingeschleift ist und zwischen dem Ladespannungsknoten N1 und der Rechteckspannungsquelle U1 ein Kondensator C1 und ein Widerstand R1 in Serie eingeschleift sind. Die Klemmdiode D1 bewirkt in Verbindung mit dem Kondensator C1 eine Anhebung der von der Rechteckspannungsquelle U2 ausgegebenen Spannung am Knoten N1 um den Betrag der Spannung der Gleichspannungsquelle. Fig. 2 zeigt diesen Zusammenhang in einem Diagramm des Spannungsverlaufs der Wechselspannungsquelle U2 und der Ladespannung U3 am Ladespannungsknoten N1 über der Zeit.

Des weiteren ist ein erstes Schaltmittel in Form einer Diode D2 und ein zweites Schaltmittel in Form eines pnp-Transistors T1 vorgesehen. Die Basis des Transistors T1 und die Anode der Diode D2 sind mit dem Ladespannungsknoten N1 verbunden. Die Kathode der Diode D2 und der Emitter des Transistors T1 sind mit einem Filterwiderstand R2 verbunden, der mit dem kapazitiven Sensorelement C3 gekoppelt ist, und der Kollektor des Transistors T1 ist mit einem Sammelkondensator C2 verbunden, dessen anderer Anschluss mit dem Bezugspotential verbunden ist.

Ein Kondensator C4 repräsentiert eine im wesentlichen konstante Grundkapazität des Sensorelements C3. Dem Sammelkondensator C2 ist ein Schalter S1 parallel geschaltet, der vor dem Beginn einer Messung geschlossen wird und somit den Sammelkondensator vollständig entleert. Wird der Spannungsverlauf am Sammelkondensator durch einen Mikrocontroller ausgewertet, kann dieser den Sammelkondensator C2 vor dem Beginn einer Messung entladen, wenn der entsprechende Eingang kurzeitig auf Bezugspotential geschaltet wird. Der Schalter S1 entfällt in diesem Fall. Das kapazitive Sensorelement C3 ist beispielsweise an eine Unterseite einer Fläche oder Abdeckung mit dielektrischen Eigenschaften angelegt.

Die Diode D2 und die Basis des Transistors T1 werden mit der Ladespannung U3 beaufschlagt, wodurch im Wechsel die Diode D2 oder der Transistor T1 leitend ist. Wenn die Ladespannung U3 ihren höheren Wert aufweist, wird die Diode D2 leitend, wodurch sich die Kapazität des Sensorelements C3 annähernd auf den Betrag der Ladespannung auflädt. Der Transistor sperrt in diesem Fall, da seine Basis-Emitter-Spannung positiv ist. Sinkt die Ladespannung U3 auf ihren niedrigeren Wert ab, sperrt die Diode D2 und die Basis-Emitter-Strecke wird leitend, d.h. der Transistor T1 schaltet durch. Folglich wird die Ladung der Sensorkapazität C3 auf den Sammelkondensator umgeladen bzw. transferiert. Die parasitären Transistorkapazitäten des Transistors T1 kompensieren einen Teil der Grundkapazität C4 des Sensorelements C3, so dass im wesentlichen nur die Kapazitätsänderung des Sensorelements C3 erfasst wird.

Die umgeladene Ladungsmenge wird durch die zu ermittelnde Kapazität C3 des Sensorelements bestimmt. Bei einer Betätigung des Näherungsschalters nimmt die Kapazität C3 zu, wodurch die Spannung am Sammelkondensator schneller ansteigt.

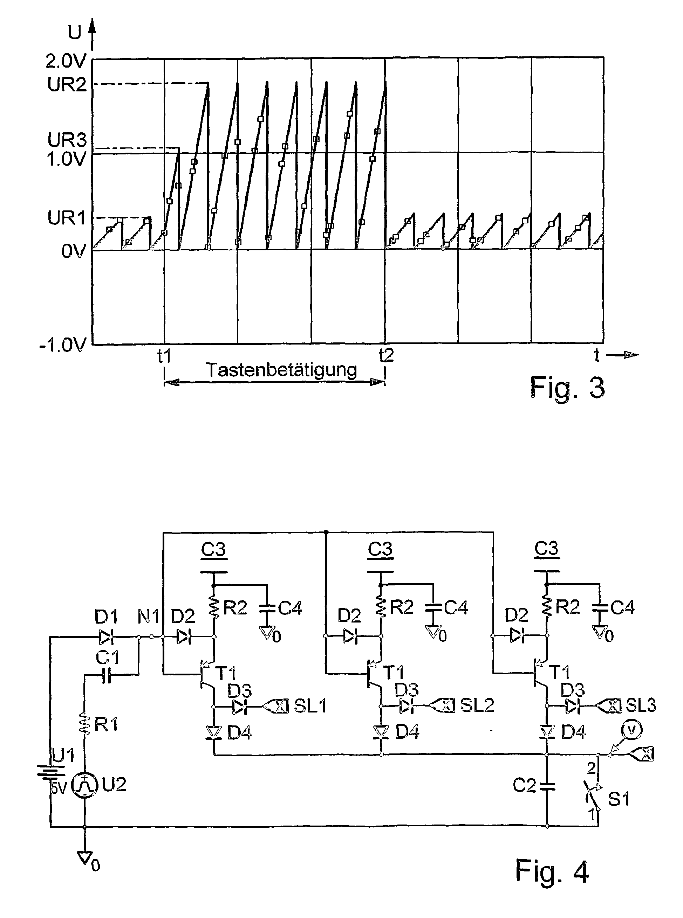

Fig. 3 zeigt ein Diagramm des Spannungsverlaufs am Sammelkondensator C2 in Abhängigkeit des Betätigungszustands des Näherungsschalters über der Zeit. Bei nicht betätigtem Näherungsschalter verläuft die Spannung sägezahnförmig zwischen der Bezugsspannung und einer ersten Rampenspannung UR1. In einem Zeitabschnitt zwischen den Zeitpunkten t1 und t2, bei betätigtem Näherungsschalter, nimmt zum Zeitpunkt t1 die Steigung der Rampe stark zu und die Spannung am Sammelkondensator C2 steigt bis zu einer Rampenspannung UR3 an. Die nachfolgenden Messzyklen erfolgen bis zum Zeitpunkt t2 mit hoher Rampensteigung, wobei jeweils eine Rampenspannung UR2 erreicht wird. Die erzielte Rampenspannung zeigt folglich den Betätigungszustand des Näherungsschalters an und kann durch eine nicht gezeigte Einheit, beispielsweise einen Mikrocontroller, ausgewertet werden.

Fig. 4 zeigt ein Schaltbild einer Schaltungsanordnung mit drei kapazitiven Sensorelementen C3, denen jeweils eine Diode D2 und ein Transistor T1 als Verbindungsmittel zugeordnet ist. Der Schaltungsteil zur Erzeugung der Ladespannung, bestehend aus den Spannungsquellen U1 und U2, der Klemmdiode D1, dem Kondensator C1 und dem Widerstand R1 ist nur einmal vorhanden und beaufschlagt die jeweiligen Verbindungsmittel mit der Ladespannung U3. Der Sammelkondensator C2 ist ebenfalls nur einfach vorhanden. Die Dioden D3 und D4, die mit dem Kollektor des Transistors T2 verbunden sind, dienen der gegenseitigen Entkopplung. Die Auswahl eines zu messenden Näherungsschalters erfolgt mit Hilfe des entsprechenden Selektionssignals SL1, SL2 bzw. SL3. Das Selektionssignal SL des ausgewählten bzw. selektierten Näherungsschalters trägt eine Spannung, die größer als die maximal auftretende Rampenspannung ist und das Selektionssignal der nicht ausgewählten Näherungsschalter trägt die Bezugsspannung. Die Ladung der nicht ausgewählten Sensorelemente fließ über die jeweilige Diode D3 ab, während die Ladung des ausgewählten Sensorelements über die entsprechende Diode D4 in den Sammelkondensator C2 transferiert wird.

Die gezeigten Schaltungsanordnungen ermöglichen die sichere Bestimmung des Betätigungszustands des oder der Näherungsschalter unter allen Betriebsbedingungen, sind kostengünstig herstellbar und unempfindlich gegenüber EMV- und HF-Störungen.

## Patentansprüche

1. Schaltungsanordnung für einen kapazitiven Näherungsschalter zur Bestimmung seines Betätigungszustands mit
- einem kapazitiven Sensorelement, dessen Kapazität (C3) sich in Abhängigkeit von seinem Betätigungszustand ändert,
- einem Sammelkondensator (C2),
- einem ersten steuerbaren Verbindungsmittel (D2), das in Abhängigkeit von einem Ansteuersignal das kapazitive Sensorelement (C3) mit einer Ladespannung (U3) beaufschlagt, und
- einem zweiten steuerbaren Verbindungsmittel (T1), das in Abhängigkeit vom Ansteuersignal das kapazitive Sensorelement (C3) mit dem Sammelkondensator (C2) zum Transfer der Ladung vom kapazitiven Sensorelement (C3) auf den Sammelkondensator (C2) verbindet,
**dadurch gekennzeichnet, dass**
- die Ladespannung (U3) eine Wechselspannung ist und die Verbindungsmittel (D2, T1) derart mit der Wechselspannung als das Ansteuersignal beaufschlagbar sind, dass im Wechsel das erste Verbindungsmittel (D2) oder das zweite Verbindungsmittel (T1) leitend ist.

2. Schaltungsanordnung nach Anspruch 1, **dadurch gekennzeichnet, dass** die Ladespannung (U3) mit Hilfe einer Gleichspannungsquelle (U1) und einer Rechteckspannungsquelle (U2) mit gemeinsamen Bezugspotential erzeugt wird, wobei zwischen einem Ladespannungsknoten (N1) und der Gleichspannungsquelle (U1) eine Klemmdiode (D1) in Sperrrichtung eingeschleift ist und zwischen dem Ladespannungsknoten (N1) und der Rechteckspannungsquelle (U2) ein Kondensator (C1) und ein Widerstand (R1) in Serie eingeschleift sind.

3. Schaltungsanordnung nach Anspruch 1 oder 2, **dadurch gekennzeichnet, dass** das erste Verbindungsmittel eine Diode (D2) ist und/oder das zweite Verbindungsmittel ein Bipolar-Transistor ist, insbesondere ein pnp-Transistor (T1).

4. Schaltungsanordnung nach Anspruch 3, **dadurch gekennzeichnet, dass** die Basis des Transistors (T1) und/oder die Anode der Diode (D2) mit dem Ladespannungsknoten (N1) verbunden sind, die Kathode der Diode (D2) und/oder der Emitter des Transistors (T1) mit einem Filterwiderstand (R2) verbunden sind, der mit dem kapazitiven Sensorelement (C3) gekoppelt ist, und der Kollektor des Transistors (T1) mit dem Sammelkondensator (C2) verbunden ist, dessen anderer Anschluss mit einem Bezugspotential verbunden ist.

5. Schaltungsanordnung nach einem der vorhergehenden Ansprüche, **dadurch gekennzeichnet, dass** dem Sammelkondensator (C2) ein Schalter (S1) parallel geschaltet ist.

6. Schaltungsanordnung nach einem der vorhergehenden Ansprüche, **dadurch gekennzeichnet, dass** sie mehrere kapazitive Sensorelemente (C3), denen jeweils ein erstes und ein zweites Verbindungsmittel (D2, T1) zugeordnet ist, und lediglich einen einzigen Sammelkondensator (C2) aufweist, der mit den jeweiligen zweiten Verbindungsmitteln (T1) über jeweils eine Entkopplungsdiode (D4) in Durchlassrichtung verbunden ist, wobei die Anode der Entkopplungsdiode (D4) durch eine Selektionsdiode (D3) in Durchlassrichtung mit einem jeweiligen Selektionssignal (SL1, SL2, SL3) verbunden ist.

7. Schaltungsanordnung nach einem der vorhergehenden Ansprüche, **dadurch gekennzeichnet, dass** das kapazitive Sensorelement (C3) dazu ausgebildet ist, an eine Unterseite einer Fläche oder Abdeckung mit dielektrischen Eigenschaften angelegt zu werden, wobei es vorzugsweise eine glatte ebene Oberfläche zur Anlage aufweist.

8. Schaltungsanordnung nach einem der vorhergehenden Ansprüche, **dadurch gekennzeichnet, dass** das kapazitive Sensorelement (C3) ein voluminöser, elastischer, vorzugsweise länglicher Körper aus elektrisch leitfähigem Material ist.

## Claims

1. A circuit arrangement for a capacitive proximity switch for the determination of an operating state and having
- a capacitive sensor element, whose capacitance (C3) changes as a function of the operating state,
- a central capacitor (C2),
- a first controllable connecting means (D2) which, as a function of a triggering signal, supplies a charging voltage (U3) to the capacitive sensor element (C3), and
- a second controllable connecting means (T1) which, as a function of the triggering signal, connects the capacitive sensor element (C3) to the central capacitor (C2) for transfer of the charge from the capacitive sensor element (C3) to the central capacitor (C2),
**characterized in that** the charging voltage (U3) is an a.c. voltage and the a.c. voltage can be supplied to the connecting means (D2, T1) as the triggering signal in such a way that, in alternating manner, the first connecting means (D2) or the second connecting means (T1) is conductive.

2. The circuit arrangement according to claim 1, **characterized in that** the charging voltage (U3) is generated with the aid of a d.c. voltage source (U1) and a square-wave voltage source (U2) with a common reference potential, a clamping diode (D1) being looped in the reverse direction between a charging voltage node (N1) and the d.c. voltage source (U1) and a capacitor (C1) and a resistor (R1) are looped in in series between the charging voltage node (N1) and the square-wave voltage source (U2).

3. The circuit arrangement according to claim 1 or 2, **characterized in that** the first connecting means is a diode (D2) and/or the second connecting means is a bipolar transistor, particularly a pnp transistor (T1).

4. The circuit arrangement according to claim 3, **characterized in that** the base of the transistor (T1) and/or the anode of the diode (D2) is connected to the charging voltage node (N1), the cathode of the diode (D1) and/or the emitter of the transistor (T1) is connected to a filter resistor (R2) which is coupled to the capacitive sensor element (C3), and the collector of the transistor (T1) is connected to the central capacitor (C2), whose other terminal is connected to a reference potential.

5. The circuit arrangement according to one of the preceding claims, **characterized in that** a switch (S1) is connected in parallel to the central capacitor (C2).

6. The circuit arrangement according to one of the preceding claims, **characterized in that** it has several capacitive sensor elements (C3) with each of which is associated a first and a second connecting means (D2, T1), and only has one single central capacitor (C2), which is connected in the conducting direction across in each case one decoupling diode (D4) to the particular second connecting means (T1), the anode of the decoupling diode (D4) being connected by a selection diode (D3) in the conducting direction with a corresponding selection signal (SL1, SL2, SL3).

7. The circuit arrangement according to one of the preceding claims, **characterized in that** the capacitive sensor element (C3) is constructed for application to an underside of a surface or a cover having dielectric characteristics and preferably has a smooth, planar surface for engagement purposes.

8. The circuit arrangement according to one of the preceding claims, **characterized in that** the capacitive sensor element (C3) is a voluminous, elastic, preferably elongated body of electrically conductive material.

## Revendications

1. Circuit pour un détecteur de proximité capacitif destiné à déterminer son état de commutation, comprenant
- un élément capteur capacitif, dont la capacité (C3) varie en fonction de son état de commutation,
- un condensateur central (C2),
- un premier moyen de liaison (D2) contrôlable, qui soumet l'élément capteur capacitif (C3) à une tension de charge (U3) en fonction d'un signal de commande, et
- un second moyen de liaison (T1) contrôlable qui, en fonction d'un signal de commande, relie l'élément capteur capacitif (C3) au condensateur central (C2) pour transférer la charge de l'élément capteur capacitif (C3) vers le condensateur central (C2),
**caractérisé en ce que**
- la tension de charge (U3) est une tension alternative et que les moyens de liaison (D2, T1) sont soumis à la tension alternative en tant que signal de commande, de telle manière que le premier moyen de liaison (D2) et le deuxième moyen de liaison (T1) sont conducteurs en alternance.

2. Circuit selon la revendication 1, **caractérisé en ce que** la tension de charge (U3) est produite à l'aide d'une source de tension continue (U1) et d'une source de tension rectangulaire (U2) avec potentiel de référence commun, sachant qu'une diode de verrouillage (D1) est branchée en sens de non-conduction entre un noeud de tension de charge (N1) et la source de tension continue (U1), et qu'un condensateur (C1) et une résistance (R1) sont branchés en série entre le noeud de tension de charge (N1) et la source de tension rectangulaire (U2).

3. Circuit selon la revendication 1 ou 2, **caractérisé en ce que** le premier moyen de liaison est une diode (D2) et/ou **en ce que** le second moyen de liaison est un transistor bipolaire, en particulier un transistor PNP (T1).

4. Circuit selon la revendication 3, **caractérisé en ce que** la base du transistor (T1) et/ou l'anode de la diode (D2) est (sont) reliée(s) au noeud de tension de charge (N1), que la cathode de la diode (D2) et/ou l'émetteur du transistor (T1) est (sont) relié(e)(s) à une résistance de filtre (R2) couplée à l'élément capteur capacitif (C3), et que le collecteur du transistor (T1) est relié au condensateur central (C2) dont l'autre branchement est relié à un potentiel de référence.

5. Circuit selon l'une des revendications précédentes, **caractérisé en ce qu'**un commutateur (S1) est branché en parallèle au condensateur central (C2).

6. Circuit selon l'une des revendications précédentes, **caractérisé en ce qu'**il présente plusieurs éléments capteurs capacitifs (C3), auxquels sont affectés respectivement un premier et un second moyens de liaison (D2, T1), et seulement un condensateur central (C2) qui est relié au second moyen de liaison (T1) correspondant, par l'intermédiaire de respectivement une diode de découplage (D4) dans le sens passant, sachant que l'anode de la diode de découplage (D4) est connectée au signal de sélection (SL1, SL2, SL3) respectif par une diode de sélection (D3) dans le sens passant.

7. Circuit selon l'une des revendications précédentes, **caractérisé en ce que** l'élément capteur capacitif (C3) est conçu de manière à être placé sur le côté inférieur d'une surface ou d'un cache présentant des propriétés diélectriques, sachant qu'il présente de préférence, pour la mise en place, une surface plane lisse.

8. Circuit selon l'une des revendications précédentes, **caractérisé en ce que** l'élément capteur capacitif (C3) est un corps volumineux, élastique et de préférence oblong, composé d'un matériau conduisant l'électricité.
